# EUROPEAN PATENT APPLICATION

(11) **EP 2 645 430 A1**
(43) Date of publication of application: **02.10.2013**
(21) Application number: 12290108.5
(22) Date of filing: 28.03.2012
(51) Int. Cl.: H01L 31/18, H01L 31/0687, H01L 31/0304, C30B 33/06, H01L 21/18, H01L 21/20, H01L 21/762

(54) **Manufacture of multijunction solar cell devices**

(71) Applicant: Soitec, 38190 Bernin (FR)
(72) Inventor: Ghyselen, Bruno, 38170 Seyssinet (FR); Arena, Chantal, 82505 Mesa AZ (US); Piccin, Mateo, 38240 Meylan (FR); Dimroth, Frank, Freiburg 79115 (DE); Grave, Matthias, 79115 Freiburg (DE)
(74) Representative: Grünecker, Kinkeldey, Stockmair & Schwanhäusser

(57) **Abstract**

The present invention relates to a method for manufacturing a multijunction solar cell device comprising the steps of providing a first substrate with a lower surface and an upper surface; providing a second substrate with a lower surface and an upper surface; bonding the first substrate to the second substrate at the upper surface of the first substrate and the lower surface of the second substrate; and subsequently forming at least one first solar cell layer on the lower surface of the first substrate and at least one second solar cell layer at the upper surface of the second substrate.

## Description

### Field of Invention

The present invention relates to the manufacture of multijunction solar cell substrates, in particular, to the manufacture of multijunction solar cell substrates comprising wafer transfer processes and the manufacture of solar cell devices for terrestrial and space-related applications.

### Background of the invention

Photovoltaic or solar cells are designed for converting the solar radiation to electrical current. In concentrator solar photovoltaic applications the incoming sun light is optically concentrated before it is directed to solar cells. For example, the incoming sun light is received by a primary mirror that reflects the received radiation toward a secondary mirror that, in turn, reflects the radiation toward a solar cell, which converts the concentrated radiation to electrical current by the generation of electron-hole pairs in III-V semiconductor or single crystal silicon, for example. Alternatively, the sunlight could be concentrated onto solar cells by using transmittive optics like Fresnel lenses.

Since different semiconductor material composition show optimal absorption for different wavelengths of the incoming solar light, multijunction solar cells have been proposed that comprise, for example, three cells showing optimal absorption in different wavelength ranges. A triple cell structure may comprise a GaInP top cell layer with a gap value of 1.8 eV, a GaAs intermediate cell layer with a gap value of 1.4 eV and a Ge bottom cell layer with a gap value of 0.7 eV, for instance. In principle, III-V or group IV semiconductors can be used as active cell layers of multijunction solar cell devices manufactured by layer transfer/bonding. Multijunction solar cells are usually manufactured by monolithic epitaxial growth. The monolithic growth process requires, in general, that any formed layers be substantially lattice matched to previously formed layers or the underlying substrate. However, the epitaxial growth of the solar cell layers on growth substrates still provides a demanding problem in view of lattice mismatches. For example, it is not suitable to epitaxially grow an InP solar cell layer on a Ge substrate, since the crystalline and optical characteristics of the InP solar cell layer would be heavily deteriorated due to crystal mismatch. In addition, in conventionally used transfer processes intermediate substrates are lost after the transfer of epitaxially grown layers.

Thus, despite the recent engineering progress there is still a need for an improved manufacturing process for multijunction solar cell devices wherein solar cell layers with a low defect rate are achieved and an intermediate substrate can be recycled.

### Description of the Invention

The present invention addresses the above-mentioned need and, accordingly, provides a method for manufacturing a multijunction solar cell device, comprising the steps of
providing a first substrate;
providing a second substrate;
bonding the first substrate to the second substrate;
and subsequently
forming at least one first solar cell layer on the exposed surface of the first substrate and at least one second solar cell layer at the exposed surface of the second substrate.

The resulting structure, thus, comprises at least one solar cell layer on either side (upper and lower surface, respectively) of bonded first and second substrates. Different from the art, bonding is performed at main surfaces of the first and the second substrate, before any solar cell layer has been formed on the substrates. Since the bonding surfaces of theses substrates can be prepared (for instance by polishing) before bonding the bond can be achieved with high quality, in particular, with a better quality as compared to bonding wherein one or two (epitaxially grown) solar cell layers are involved.

Contacting and bonding can be performed at relatively high temperatures of about 400 °C to 600 °C and more preferably between 450 °C and 550 °C. Preferably, the contacting step is performed at room temperature followed by an annealing step reaching max temperature between 400° and 600°C, although it is not excluded to perform the contacting step at a higher temperature. This bonding step is crucial for the quality of the resulting structure and it is favourable to perform high-temperature bonding anneal in order to achieve a high-quality bonding interface between the two substrates without significant defects.

In case of direct bonding, which forms the preferred approach, the polishing of the to be bonded may be performed in order to smooth the surface, to 0.5 nm RMS over a field of 5x5 micrometers for example, to obtain a enhanced bonding strength and improved efficiency and reliability of the subsequent solar cell. Alternatively, an electrically conductive, optically transparent material can be used as a bonding layer and facilitates the adhesion of the two substrates.

The second substrate can be a relatively thin substrate of some 100 micrometers, for example, or from about 100 micrometer to about 300 micrometers, to provide mechanical stability to the resulting structure. In particular, the second substrate can be made of or comprise GaAs.

The first substrate can be provided in form of an engineered substrate, in particular, comprising sapphire.

The term "engineered substrate" comprises a substrate that is different from a mere pure bulk substrate but rather includes a layer or interface that is formed in the substrate in order to facilitate its removal from the structure resulting of the bonding of the first and second wafer structures. In particular, the "engineered substrate" may comprise a zipper layer between a seed layer and a base substrate. In particular, the engineered substrate may comprise a base substrate that is detached from the seed layer in the step of removal of the engineered substrate.

Detachment by means of the zipper layer allows for recycling the detached substrate.

In the document, the expression "detachment of the engineered substrate" should be interpreted as the detachment of the base substrate. This detachment step may be followed by the removal of the possible residue of the zipper layer (if any), and of the removal of the seed layer from the remaining structure.

The zipper layer may be a weakened layer formed, e.g., by an appropriate treatment, for instance, a hydrogen or helium implantation in a substrate, that delimit an upper seed layer and a lower base substrate.

The zipper layer may be formed by a buried porous layer by anodic etching at a surface of the base substrate. Then epitaxial growth of the seed layer can be performed on top of the porous layer.

The zipper layer may be provided in form of an absorbing layer for laser lift-off, chemical lift off or mechanical splitting in an intermediate strained layer during an epitaxy sequence: SiGe in Si matrix, in particular, an intermediate strained layer of SiGe at 20% in a Si substrate. In this alternative, the zipper layer may be formed by the seed layer itself, for instance the seed layer can be selectively and chemically etched away to detach the engineered substrate.

The zipper layer may also be formed of a SiN absorbing layer for laser lift-off inserted between a seed layer and a transparent base substrate, as known for example from W02010015878.

Another possibility for an engineered substrate reads as follows A removable (presenting a low bonding energy of less than 1.5 J/m², and preferentially less than 1J/m²) bonding interface is formed between facing surfaces of a seed layer and a base support. In that possibility, the zipper layer is formed by the removable bonding interface. A first solar cell layer may be grown by epitaxy on the seed layer while preserving the removable character of the bonding interface, with the engineered substrate being heated to an epitaxial growth temperature. The low energy bonding is obtained by performing a treatment for augmenting the roughness of the facing surface of one of the seed layer or the substrate in particular carried out by chemical attack or etching, by effecting a treatment for decreasing hydrophilicity of the facing surface of one of the seed layer or the substrate (or the bonding layer in SiO₂ or Si₃N₄ on each of them). Moreover, a different material for the bonding layer can be chosen such that weak intrinsic mutual chemical affinity of the interface materials is achieved. The detachment of the base substrate may be performed by application of a thermal treatment or mechanical stresses applied from a jet of fluid or a blade, for example. This is disclosed for instance in WO03/063214.

As already mentioned, the engineered substrate may include a seed layer formed at the top of the zipper layer or removable bonding interface. The seed layer is transferred from the seed substrate to a base substrate by layer transfer from wafer to wafer, for example, by the Smart Cut™ process. The seed layer may contain or not an epitaxial layer that has been formed originally by epitaxy on the seed substrate. Alternatively, the seed layer has been transferred or detached from a bulk seed substrate. In a preferred embodiment of the present invention, the seed layer is not used as a solar cell layer but rather a first solar cell layer is grown on the seed layer.

The first substrate may be provided in form of an InP bulk substrate comprising H or He implants in some implantation layer at which a part of the InP bulk substrate can be detached after bonding to the second substrate. The first substrate may also be an engineered substrate in the above-described sense. In particular, the first substrate may comprise a zipper layer (see description above) and the method may comprise the step of detaching a part of the first engineered substrate at the zipper layer.

Anyway, thinning at least one of the first and second substrates after bonding and before the formation of the solar cell layers may be comprised in the inventive method according to exemplary embodiments.

According to an example, the first substrate is provided in form of an InP on sapphire substrate and the InP layer is bonded to the second substrate followed by detachment of the sapphire base and optionally removal of remaining material on the the InP layer.

Whatever the method chosen to provide the InP layer, it is preferable that the thickness of this layer be below 10 micrometer and more preferably less than 1 micrometer. A solar cell layers can be grown on the InP layer (substrate) with high crystal and electrical quality. For example, a dislocation density of less than 10⁶ /cm² can be achieved.

As already mentioned the main surfaces of the first and second substrate may be prepared, for instance by polishing. This not only holds for the bonding surfaces but also for the free surfaces whereupon the semiconductor layers are grown, since polishing in this case enhances the crystalline quality of the (epitaxially) grown semiconductor layers.

Further, the method may comprise forming a contact on the at least one first solar cell layer. Furthermore, before forming a contact the corresponding solar cell layer may be patterned to form a mesa whereupon the contact can be provided.

The structure comprising the (thinned) first and second substrates and at least one solar cell layer on either main surface of the bonded substrates may be further bonded to a base substrate. The bonding to the base substrate can be performed by means of an electrically conductive (metallic, or with conductor oxides, transparent conductor oxide TCO, silicide or by direct bonding, etc) bonding layer formed on the first solar cell layer and/or the base substrate. An electrically conductive layer particularly helps also to provide for thermal conductivity to the base substrate that may function as a heat sink or may be connected to a heat sink and preferably is itself thermally and electrically conductive. The conductive bonding may be obtained by forming an eutectic Au/Sn or by thermocompression.

In this embodiment bonding of the first and second substrates is performed while the (final) base substrate is not present in the structure yet. Possibly, no final substrate is necessary since the second substrate is thick enough to provide mechanical stability to the structure.Thus, a risk of metallic contaminations is avoided during bonding thermal treatment such that high temperature may be used. Moreover, the expansion of the base substrate that would be different from the expansion of the first and second substrates at such a temperature due to different coefficient of thermal expansion (CTE) would damage the structure, in particular it would weakened the bonding interface.

According to a particular variant, in the above-described examples, the at least one first solar cell layer comprises two layers, a first and a second layer, that has been grown by epitaxy on the first layer, and the at least one second solar cell layer also comprises two layers, namely a third and a fourth layer that has been grown by epitaxy on the third layer. According to a particular example, the first layer (bottom cell) comprises or consists of GaInAs and/or the second layer comprises or consists of GaInAsP and/or the fourth layer (top cell in the finished multijunction solar cell device) comprises or consists of GaInP and/or the third layer comprises or consists of GaAs. Thus, a four-cell multijunction solar cell device is achieved (comprising two solar cell layers on one main surface of a first substrate and one main surface of a second substrate) wherein the material of each cell is optimized for a particular wavelength of the incoming solar light. No layer transfer of solar cell layers is necessary during the entire manufacturing process. It should also be noted that in the above-described examples one single detachment step (detaching the first substrate) only may be involved.

According to another embodiment the inventive method for manufacturing a multijunction solar cell device further comprises the step of forming a cap layer on the at least one first solar cell layer (formed on the first substrate). The cap layer protects the at least one first solar cell layer during the further processing. In this context, the method may comprise the steps of
forming a mesa of the at least one second solar cell layer after forming the cap layer on the at least ne first solar cell layer and forming a contact on the resulting mesa;
removing the cap layer after the formation of the mesa; and
bonding a base substrate (for example, a base substrate as described above) to the at least one first solar cell layer after the removal of the cap layer.

The present invention also provides an intermediate semiconductor device, comprising
a first substrate, in particular, an InP substrate;
a second substrate, in particular, a GaAs substrate, bonded at a lower surface to an upper surface of the first substrate;
at least one first solar cell layer formed on a lower surface of the first substrate and at least one second solar cell layer formed on the upper surface of the second substrate.

The intermediate semiconductor substrate may comprise a second solar cell layer formed on a lower surface of the first substrate, a first solar cell layer formed on the second solar cell layer, a third solar cell layer formed on an upper surface of the second substrate and a fourth solar cell layer formed on the third solar cell layer. In this configuration, according to a particular example, the first layer comprises or consists of GalnAs and/or the second layer comprises or consists of GaInAsP and/or the third layer comprises or consists of GaAs and/or the fourth layer comprises or consists of GaInP.

Furthermore, the intermediate semiconductor substrate may comprise a base substrate, in particular, a base substrate made of Cu, Mo, W or Si or Al, in particular aluminium sheet bonded to the first solar cell layer, in particular, by a conductive bonding layer.

In addition, it is provided a multijunction solar cell device obtainable by one of the above-described examples of the method for the manufacture of a multijunction solar cell device according to the present invention.

Additional features and advantages of the present invention will be described with reference to the drawings. In the description, reference is made to the accompanying figures that are meant to illustrate an embodiment of the invention. It is understood that such an embodiments does not represent the full scope of the invention.
Figure 1 illustrates an example for the inventive method for the manufacturing of a multijunction solar cell comprising a substrate bonding step.
Figure 2 illustrates an example for the inventive method for the manufacturing of a multijunction solar cell wherein an engineered GaAs on sapphire is employed.

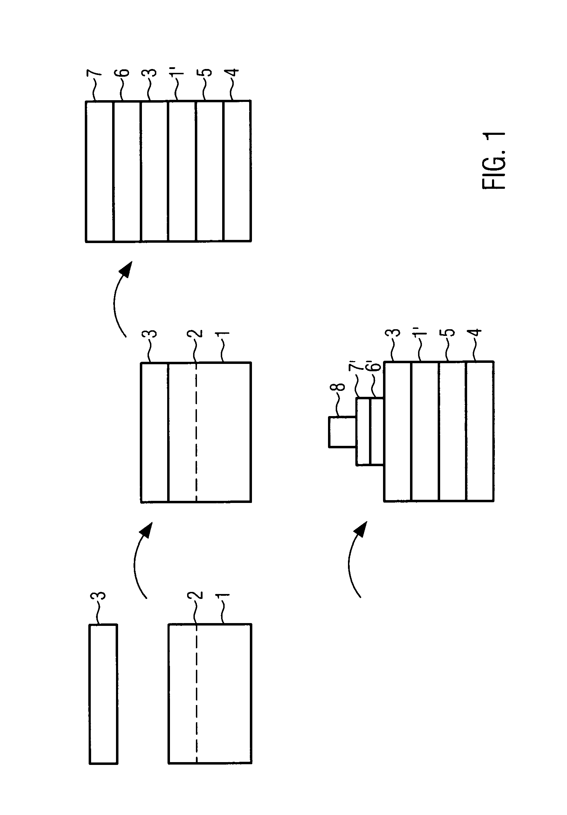

An example for the inventive method for the manufacturing of a multijunction solar cell comprising four solar cell layers is shown in Figure 1. A first substrate 1 comprising an implantation layer (weakened layer) 2 for later detachment of the first substrate 1 is provided. For example, the first substrate 1 is an InP bulk substrate. Due to the provided implantation layer substrate 1 represents an engineered substrate in the sense of the present application (see description above).

Furthermore, it is provided a second substrate 3. The second substrate 3 may be a thin bulk GaAs, presenting a thickness of 200 micrometer. The main surfaces (upper and lower surfaces) of both the first 1 and the second substrate 3 according to the shown example are polished in order to facilitate the subsequent processing. The lower surface of the first substrate 1, however, may not be polished before thinning after bonding (see below).

As it is illustrated in Figure 1, the first 1 and the second 3 substrates are bonded together. Bonding can be performed at relatively high temperatures of about 400 °C to 600 °C and more preferably between 450 °C and 550 °C. This bonding step is crucial for the quality of the resulting multijunction solar cell and it is favourable to perform high-temperature bonding in order to achieve a high-quality bonding interface between the lower surface of the second substrate 3 and the upper surface of the first substrate 1. After bonding the main part of the bulk InP substrate 1 is detached by means of the implantation layer as it is known in the art. The detached bulk InP can be recycled. The thickness of the resulting InP layer 1' may be in the range of 50 nm to 1 µm. The free (lower) surface of the InP layer may be prepared, by polishing, etching, annealing, etc.

Subsequently, a second 5 and a first 4 solar cell layer are formed on the free surface of the InP layer 1. Similarly, a third 6 and fourth 7 solar cell layer are formed on the free surface of the second substrate 3. Optionally, a cap layer (not shown in Figure 1) may be formed on the lower surface of the first solar cell layer 4 in order to protect the same during the further processing.

The four solar cell layers 4-8 show absorption maxima for incident solar light for different wavelengths. The first solar cell layer 4 becomes the bottom cell and the fourth solar cell layer 7 becomes the top cell in the finished multijunction solar cell device. It is therefore important that the material and thicknesses of the second substrate 3 and layer 2 be selected to present a low absorption for incident light in the wavelength absorbed by solar cell layers 4 and 5.

According to the present example all of the four monocrystal solar cell layers 4-8 are formed by epitaxial growth. In principle, the material of the solar cell layers can be selected form III-V semiconductors of the group consisting of InGaAs, GaAS, AlGaAs, InGaP, InP and InGaAsP. For example, the first solar cell layer 4 may be comprised of InGaAs, the second solar cell layer 5 may be comprised of InGaP, InGaAsP or InP, the third solar cell layer 7 may be comprised of GaAsP or GaAs, and the fourth solar cell layer 8 may be comprised of InGaP or InAlAs. Appropriate tunnel junction layers may be provided between particular ones of the solar cell layers by deposition or growth on a respective solar cell layer.

In the next step illustrated in Figure 1 the resulting structure is subject to some finish processing comprising the formation of a plurality of mesas comprising etched solar cell layers 6' and 7'. The formation of the mesas can be achieved by lithographic processing after the formation of an appropriately patterned photoresist and optionally formed anti-reflective coating. An electrical contact 8 is formed on the patterned fourth solar cell layer 7'.

In a possible but not necessary approach, the thus obtained structure can be bonded to a base substrate (not shown in Figure 1). This bonding process may be performed by direct conductive bonding the first solar cell layer 4 to the base substrate or by means of a metallic bonding layer that is formed on the exposed surface of the first solar cell layer 4 or the base substrate before the bonding process. It is also possible to form a metallic bonding layer on the exposed surface of the first solar cell layer 4 and the base substrate, respectively. It is noted that the base substrate may function as a thermally and electrically conductive substrate. Particularly, the base substrate may be made of Cu or Al, in particular, made of an aluminium sheet stiff enough to provide support of the stacked solar cell layers. Other envisaged candidates for the base substrate comprise Si, such as doped silicon, Mo and W.

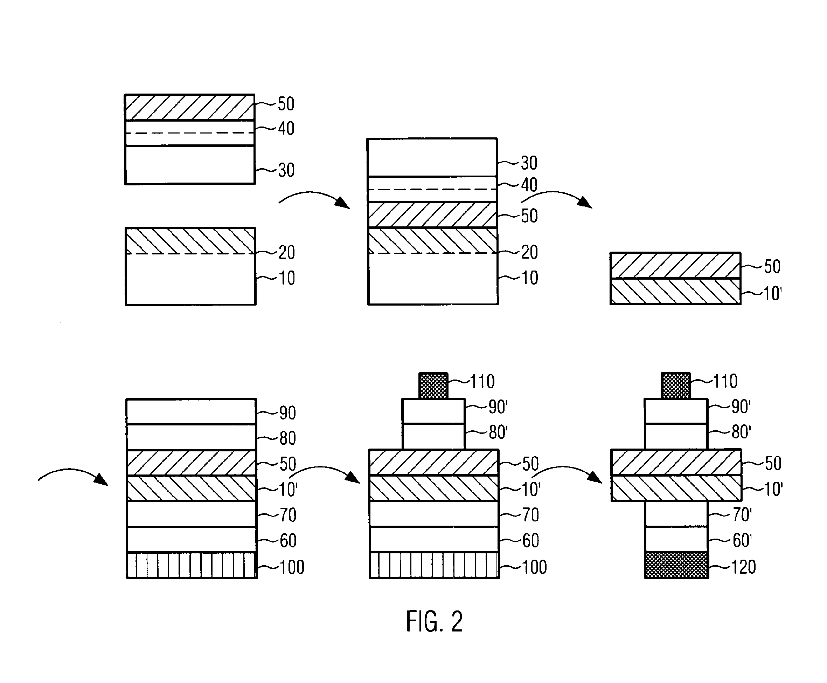

Figure 2 illustrates another example for the herein disclosed method wherein the second substrate employed in the embodiment shown in Figure 1 is provided in form of an engineered GaAs on sapphire substrate. A first InP bulk substrate 1 comprising a weakened layer 2 caused by the implantation of H or He is provided. Moreover, an engineered GaAs on sapphire substrate comprising a sapphire bulk 30, a zipper layer 40 and a GaAs layer 50 is provided. The zipper layer is a layer at which subsequent detachment of the first engineered substrate is performed and may be a weakened layer or interface as described above. Detachment by means of the zipper layer allows for recycling the detached substrate.

Sapphire may preferably be chosen in view of its coefficient of thermal expansion which is of importance for the temperature change (up and down) during epitaxy and for the further processing, in particular, bonding step (see below). Moreover, sapphire is transparent to laser light and can, thus, allow for laser lift-off in a later processing step (see below).

The first substrate 1 and the second engineered substrate are bonded at the upper surface of the first substrate 1 and the GaAs layer 50 of the second engineered substrate. After the bonding the major part of the bulk InP of the first substrate 1 is detached by means of the weakened layer 2. Moreover, the sapphire base 30 is detached from the GaAs layer 50 by means of the zipper layer 40, for example, the second engineered substrate is cleaved at the zipper layer 40 allowing the detachment of the sapphire base 30. For instance, the zipper layer 40 may be provided in form of a weakened layer (similar to the one formed in the first substrate 1) formed by the implantation of ionic species, for example, hydrogen or helium ions.

The detachment of the sapphire base substrate 30 can be mediated by the application of mechanical forces to delaminate at the weakened layer formed by hydrogen or helium ions. Residue of the base substrate may be removed by etching and/or polishing, for example. It is noted that the detached sapphire base substrate 30 can be recycled to form a new engineered substrate for the re-usage in the manufacture of further multijunction solar cells.

Then, a second solar cell layer 70 and a first solar cell layer 60 are subsequently formed on the InP layer 10' that is bonded to the GaAs layer 50. On the other hand, a third solar cell layer 80 and a fourth solar cell layer 90 are formed on the GaAs layer 50. In addition, in the shown example, a cap layer 100 is provided for the protection of the first and second solar cell layers 70 and 60 during the further processing.

The third and fourth solar cell layers 80 and 90 are then patterned to form mesas 80' and 90'. A contact 110 is formed atop of the mesa 90' of the fourth solar cell layer 90. Subsequently, the cap layer 100 is removed from the second solar cell layer 60 and the first 70 and second 60 solar cell layers are also patterned to obtain mesas 70' and 60'. After the patterning is completed a base substrate 120 is bonded to the mesa 60' resulting from the second solar cell layer 60.

All previously discussed embodiments are not intended as limitations but serve as examples illustrating features and advantages of the invention. It has to be understood that some or all of the above described features can also be combined in different ways. It has to be understood that some or all of the above described features can also be combined in different ways. In particular, it is possible according to the invention to form mutlijunction solar cells not only composed of 4 junctions (as generally disclosed in the previous embodiments) but also 2, 3, 5 or more.

## Claims

1. Method for manufacturing a multijunction solar cell device comprising the steps of
providing a first substrate;
providing a second substrate;
bonding the first substrate to the second substrate;
and subsequently
forming at least one first solar cell layer on the exposed surface of the first substrate and at least one second solar cell layer at the exposed surface of the second substrate.

2. The method according to claim 1, further comprising thinning at least one of the first and second substrates after bonding and before the formation of the solar cell layers.

3. The method according to claim 1 or 2, wherein the first substrate is an engineered first substrate.

4. The method according to claim 3, wherein the first substrate comprises a zipper layer and wherein the method comprises the step of detaching a part of the first engineered substrate at the zipper layer.

5. The method according to claim 4, wherein
the zipper layer is formed by an electromagnetic absorbing layer between a seed layer and a base layer of the first engineered substrate and detachment of the first engineered substrate is performed by laser lift-off; or
the zipper layer is a weakened layer, in particularly, formed be H and/or He implants, and detachment of the first engineered substrate is performed by application of thermal or mechanical strain; or
the zipper layer is a porous layer;
the zipper layer represents a low bonding interface.

6. The method according to one of the preceding claims, further comprising polishing the surfaces of the substrates to be bonded.

7. The method according to one of the preceding claims, further comprising forming a contact on the at least one first solar cell layer after bonding or forming a contact on the at least one second solar cell layer after bonding.

8. The method according to one of the preceding claims, wherein the first substrate comprises InP.

9. The method according to one of the preceding claims, wherein the second substrate comprises or consists of GaAs.

10. The method according to one of the preceding claims, wherein the second substrate is a second engineered substrate.

11. The method according to claim 10, wherein the second engineered substrate is a GaAS on sapphire substrate.

12. The method according to claim 11, further comprising detaching the sapphire base of the second engineered substrate after bonding of the first and the second substrate.

13. The method according to one of the preceding claims, wherein the at least one first solar cell layer comprises a first and a second layer on the first layer and/or the at least one second solar cell layer comprises a third and a fourth layer on the third layer.

14. The method according claim 13, wherein the first layer comprises or consists of GalnAs and/or the second layer comprises or consists of GalnAsP and/or the third layer comprises or consists of GaAs and/or the fourth layer comprises or consists of GalnP.

15. The method according one of the preceding claims, wherein the step of bonding the first and the second substrates is performed at a temperature of about 400 °C to about 600 °C, in particular, between 450 °C and 550 °C.

16. The method according one of the preceding claims, further comprising bonding a base substrate in particular, a base substrate made of Cu, Mo, W or Si or Al, in particular, aluminium sheet, to the at least one first solar cell layer after detachment of the first substrate.

17. The method according one of the preceding claims, further comprising forming a cap layer on the at least one first solar cell layer.

18. The method according to claim 17, further comprising
forming a mesa of the at least one second solar cell layer after forming the cap layer on the at least ne first solar cell layer and forming a contact on the resulting mesa;
removing the cap layer after the formation of the mesa; and
bonding a base substrate to the at least one first solar cell layer after the removal of the cap layer.

19. The method according one of the preceding claims, wherein the step of bonding of the first and second substrates is performed by direct bonding or by bonding by a metallic or transparent conductor oxide bonding layer.

20. Multijunction solar cell device, comprising
a seed layer, in particular, an InP layer;
a substrate, in particular a GaAs substrate, bonded to the seed layer;
at least one first solar cell layer formed on the exposed surface of the seed layer and at least one second solar cell layer formed on the exposed surface of the substrate.

21. The multijunction solar cell device according to claim 20, comprising a second solar cell layer formed on the exposed surface of the seed layer, a first solar cell layer formed on the second solar cell layer, a third solar cell layer formed on the exposed surface of the substrate and a fourth solar cell layer formed on the third solar cell layer wherein the first layer comprises or consists of GalnAs and/or the second layer comprises or consists of GaInAsP and/or the third layer comprises or consists of GaAs and/or the fourth layer comprises or consists of GaInP.

22. The multijunction solar cell device according to claim 20 or 21, further comprising a base substrate, in particular, a base substrate made of Cu, Mo, W or Si or Al, in particular aluminium sheet bonded to the first solar cell layer, in particular, by a conductive bonding layer.

23. The multijunction solar cell device according to one of the claims 20 to 22, wherein the substrate has a thickness less than 350 micrometers or between 200 micrometers and 340 micrometers or less than 200 micrometers.

24. The multijunction solar cell device according to one of the claims 20 to 23, wherein the seed layer has a thickness of less than 10 microns, preferably less than 1 micron.

25. The multijunction solar cell device according to one of the claims 20 to 24, wherein the substrate and the seed layer are essentially transparent to wavelengths absorbed by the at least one first solar cell layer.

26. The multijunction solar cell device according to one of the claims 20 to 25, further comprising an electrically and optically conductive bonding layer between the seed layer and the substrate.
